Europäisches Patentamt

**European Patent Office**

**Office européen des brevets**

(19)

(11) Numéro de publication: **0 041 427
B1**

(12) **FASCICULE DE BREVET EUROPEEN**

(45) Date de publication du fascicule du brevet:
**16.05.84**

(51) Int. Cl.³: **G 11 C 27/02**, G 11 C 19/28

(21) Numéro de dépôt: **81400787.8**

(22) Date de dépôt: **19.05.81**

(54) **Dispositif d'échantillonnage et maintien à capacité MOS.**

(30) Priorité: **03.06.80 FR 8012280**

(43) Date de publication de la demande:
**09.12.81 Bulletin 81/49**

(45) Mention de la délivrance du brevet:
**16.05.84 Bulletin 84/20**

(84) Etats contractants désignés:
**DE GB NL**

(56) Documents cités:
**US - A - 4 067 001
US - A - 4 139 782**

(73) Titulaire: **THOMSON-CSF, 173, Boulevard Haussmann,
F-75379 Paris Cedex 08 (FR)**

(72) Inventeur: **Berger, Jean-Luc, THOMSON-CSF
SCPI 173, bld Haussmann, F-75360 Paris Cedex 08 (FR)**

(74) Mandataire: **Mayeux, Michèle et al, THOMSON-CSF
SCPI 173, Bld Haussmann, F-75379 Paris Cedex 08 (FR)**

EP 0 041 427 B1

**0 041 427**

## Dispositif d'échantillonnage et maintien à capacité MOS

La présente invention concerne un dispositif d'échantillonnage et maintien à capacité MOS.

On connaît dans l'art antérieur essentiellement deux types de dispositifs d'échantillonnage et maintien réalisés en technologie MOS.

Ce sont:

— d'une part, les dispositifs qui comportent un transistor MOS classique dont la source reçoit la tension d'entrée à échantillonner et dont la grille reçoit une tension d'échantillonnage. Le drain du transistor MOS ou TMOS est relié à une capacité de stockage et à un étage suiveur de tension, à haute impédance d'entrée, qui peut être constitué de deux TMOS en série. La capacité de stockage n'est pas une capacité MOS. Elle peut être intégrée dans le substrat semiconducteur où sont intégrés les TMOS, mais elle comporte deux armatures métalliques. Le transfert des charges du drain du TMOS vers la capacité de stockage se fait par la connexion qui existe entre ce drain et l'une des armatures de la capacité de stockage;

— enfin, d'autre part, les dispositifs qui comportent un transistor MOS du type tétrode ayant deux grilles. La grille la plus proche de la source du TMOS est la grille d'échantillonnage qui reçoit la tension d'échantillonnage; cette grille est suivie par une grille d'isolement portée à un potentiel constant. Le drain du TMOS est relié comme dans le cas précédent à une capacité de stockage, qui n'est pas une capacité MOS, et à un étage suiveur de tension.

Les performances des dispositifs d'échantillonnage et maintien sont essentiellement définies par deux caractéristiques qui sont;

— d'une part, le temps d'acquisition de chaque nouvel échantillon de tension prélevé sur la tension d'entrée du dispositif. Ce temps doit être minimum;

— d'autre part, la capacité de couplage parasite entre la grille et le drain du TMOS du dispositif. Ce couplage doit être réduit au maximum.

En voulant améliorer l'une de ces caractéristiques, on aboutit souvent à détériorer l'autre.

Ainsi, dans les dispositifs d'échantillonnage et maintien en technologie MOS selon l'art antérieur, qui comportent un TMOS classique, on est conduit à augmenter la valeur de la capacité de stockage pour réduire l'effet de la capacité de couplage parasite. L'inconvénient est qu'en même temps, on augmente le temps d'acquisition.

Par ailleurs, si on examine à quoi est due la capacité de couplage parasite, on s'aperçoit qu'il y a essentiellement trois causes, qui sont:

— le recouvrement entre la grille d'échantillonnage et la diffusion drain du TMOS;

— le couplage entre la grille d'échantillonnage et le canal MOS du TMOS. Lors du passage de la tension d'échantillonnage du niveau haut au niveau bas, une partie des porteurs du canal est restituée aux diffusions source et drain. Lors de cette restitution, le drain qui est un point à haute impédance voit son potentiel s'abaiser de $Q_c/C$, où $Q_c$ représente la quantité de charges restituée et C la valeur de la capacité de stockage. Inversement, lors du passage de la tension d'échantillonnage du niveau bas au niveau haut, le drain subit un appel de charges qui élève son potentiel;

— enfin, une autre cause à la capacité de couplage parasite est le couplage de la grille d'échantillonnage du TMOS avec le drain par l'intermédiaire du substrat dont la résistance n'est pas nulle.

Dans les dispositifs d'échantillonnage et maintien en technologie MOS selon l'art antérieur, qui comportent un TMOS du type tétrode, il n'y a plus, grâce à la grille d'isolement, de recouvrement entre la grille d'échantillonnage du TMOS et sa diffusion drain.

Par contre, le couplage entre la grille d'échantillonnage et le canal MOS du TMOS existe toujours. Pour diminuer l'importance de l'appel ou de la restitution de charges que subit le drain du TMOS, on augmente la longueur de la grille d'isolement du TMOS. L'inconvénient est qu'en même temps, on augmente les temps d'acquisition.

On s'aperçoit donc qu'avec les dispositifs d'échantillonnage et maintien réalisés en technologie MOS selon l'art antérieur, il est difficile de réaliser un compromis de façon à avoir à la fois un temps d'acquisition et une capacité de couplage parasite satisfaisants.

La présente invention concerne un dispositif d'échantillonnage et maintien, constitué par un transistor MOS du type tétrode, qui fonctionne en régime triode et qui comprend:

— une première diode connectée à la tension d'entrée du dispositif;

— une grille d'échantillonnage reliée à un potentiel variable et une grille d'isolement reliée à un potentiel constant, qui suivent la première diode;

— enfin, une deuxième diode qui suit la grille d'isolement, et qui est connectée à un étage suiveur de tension à grande impédance d'entrée qui fournit la tension de sortie du dispositif, dispositif caractérisé en ce que le stockage des charges correspondant à chaque échantillon de la tension d'entrée est réalisé sur une capacité MOS ayant pour armature la grille d'isolement et en ce que la longueur de la grille d'isolement est nettement supérieure à la longueur de la grille d'échantillonnage.

Ainsi, dans le dispositif selon l'invention, on supprime totalement la capacité de stockage, qui n'est pas une capacité MOS, des dispositifs selon l'art antérieur.

On réduit ainsi le temps d'acquisition au temps d'équilibrage du potentiel de surface sous les grilles d'échantillonnage et d'isolement avec la source du TMOS qui reçoit la tension d'entrée. Contrairement à ce qui se passe pour les dispositifs selon l'art antérieur, le temps d'acquisition ne comporte plus le temps nécessaire à la charge d'une capacité de stockage externe à travers un transistor MOS.

On peut alors se permettre d'augmenter la gongueur de la grille d'isolement de façon à diminuer la capacité de couplage parasite entre la grille d'échantillonnage et le drain du TMOS tout en conservant le même temps d'acquisition que dans les dispositifs selon l'art antérieur.

Avec le dispositif selon l'invention, il est possible d'avoir à la fois un temps d'acquisition et une capacité de couplage parasite satisfaisants.

Ainsi, avec le dispositif d'échantillonnage et maintien à capacité MOS selon l'invention, on obtient un temps d'acquisition égal à celui des dispositifs selon l'art antérieur, en même temps qu'on obtient:

— une réduction, par 3 environ, du parasite par couplage avec le canal;
— une réduction, par 10 environ, du parasite par couplage avec le substrat;
— et enfin, une réduction de la surface d'encombrement du dispositif, par 1,5 environ.

D'autres objets, caractéristiques et résultats de l'invention ressortiront de la description suivante, donnée à titre d'exemple non limitatif et illustrée par les figures annexées qui représentent:

— les fig. 1 et 2, les schémas de deux dispositifs d'échantillonnage et maintien en technologie MOS, selon l'art antérieur;
— les fig. 3a, b, et c, une vue en coupe longitudinale d'un mode de realisation du dispositif d'échantillonnage et maintien à capacité MOS selon l'invention, et deux schémas illustrant son fonctionnement;
— la fig. 4, un schéma électrique équivalent aux dispositifs d'échantillonnage et maintien qui illustre le couplage par le substrat;
— la fig. 5, une vue de dessus d'un autre mode de réalisation du dispositif selon l'invention représenté sur la fig. 3a.

Sur les différentes figures, les mêmes repères désignent les mêmes éléments, mais, pour des raisons de clarté, les cotes et proportions des différents éléments ne sont pas respectées.

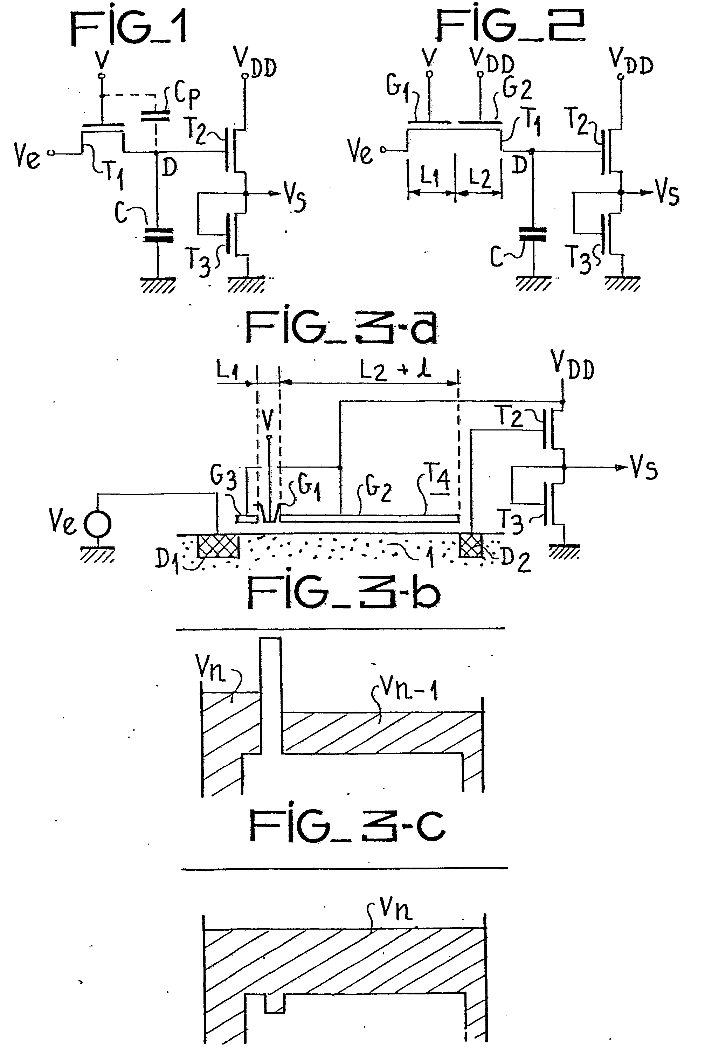

Les fig. 1 et 2 représentent les schémas de deux dispositifs d'échantillonnage et maintien, en technologie MOS, selon l'art antérieur.

Le dispositif représenté sur la fig. 1 comporte un TMOS classique $T_1$ dont la source reçoit la tension d'entrée $V_e$ à échantillonner. La grille reçoit une tension d'échantillonnage V qui varie périodiquement entre un niveau bas et un niveau haut V.

Le drain de $T_1$ est relié en un point D à une capacité de stockage C, qui comme on l'a vu précédemment n'est pas une capacité MOS. Au point D, est relié en étage suiveur de tension, a haute impédance d'entrée, qui peut être constitué de façon connue par deux TMOS $T_2$ et $T_3$ en série entre une tension de polarisation $V_{DD}$ et la masse. La grille de $T_2$ est reliée au point D et la grille de $T_3$ est reliée au point commun aux deux TMOS $T_2$ et $T_3$ où on recueille la tension de sortie du dispositif $V_S$.

Sur la fig. 1, on a représenté symboliquement en pointillés la capacité de couplage parasite $C_P$ qui existe entre la grille et le drain du TMOS.

Cette capacité introduit au point D un signal parasite:

$$V_P = \frac{C_P}{C + C_P} \cdot V.$$

On constate donc que, comme cela a été dit précédemment, on est conduit à augmenter la valeur de la capacité de stockage C pour réduire l'effet de la capacité de couplage parasite $C_P$ ce qui augmente le temps d'acquisition.

Le dispositif représenté sur la fig. 2 diffère de celui de la fig. 1 car il comporte un TMOS du type tétrode. La source qui reçoit $V_e$ est suivie par la grille d'échantillonnage $G_1$ portée à V. Cette grille est suivie par une grille d'isolement $G_2$ portée au potentiel constant $V_{DD}$.

Comme on l'a vu précédemment, on a intérêt pour diminuer le couplage parasite entre la grille d'échantillonnage et le drain de $T_1$, à augmenter la longueur $L_2$ de la grille $G_2$, la largeur de cette grille étant constante.

L'inconvénient est qu'on augmente ainsi le temps d'acquisition comme on va le voir dans ce qui suit.

Dans les dispositifs selon l'art antérieur, comme dans celui selon l'invention, les TMOS utilisés fonctionnent en régime triode.

Si on néglige le temps d'équilibrage des potentiels de surface sous les grilles $G_1$ et $G_2$ devant le temps nécessaire à la charge ou a la décharge de la capacité C, le potentiel $V_D$ du drain du TMOS $T_1$ s'exprime en fonction du temps t par la relation:

$$V_D = V_e + \frac{2\,V_0 \cdot V'}{V' + (2\,V_0 - V')\,e^{t/\tau}}$$

avec $V_o = V - V_T - V_e$, où $V_T$ est la tension de seuil de $T_1$, avec V' la différence de potentiel initiale entre source et drain de $T_1$, et avec

$$\tau = \frac{C}{\mu \cdot (W/L) \cdot C_{ox} \cdot V_0},$$

où $\mu$ est la mobilité des porteurs, $C_{ox}$ la capacité d'oxyde sous la grille par unité de surface et W/L, le rapport largeur sur longueur de la grille de $T_1$.

Pour la charge comme pour la décharge de C, le potentiel $V_D$ tend donc exponentiellement vers $V_e$ avec une constante de temps qui est proportionnelle à la longueur L du canal. Dans le cas de la fig. 2, on a : $L = L_1 + L_2$.

Pour atteindre 90% de $V_e$, les temps de charge $t_c$ et de décharge $t_d$ sont les suivants:

$$t_c = 2 \cdot \tau \tag{1}$$
$$t_d = 2,6 \cdot \tau \tag{2}$$

Si on augmente $L_2$ pour diminuer le couplage avec le drain, on augmente le temps d'acquisition.

La fig. 3a représente une vue en coupe longitudinale d'un mode préferé derealisation du dispositif d'échantillonnage et maintien à capacité MOS selon l'invention.

Ce dispositif est constitué par un TMOS du type tétrode $T_4$ qui fonctionne en régime triode.

Deux diodes $D_1$ et $D_2$ sont diffusées dans le substrat semiconducteur 1, en silicium par exemple.

La diode $D_1$ est reliée à la tension d'entrée $V_e$ et joue le rôle de source.

La diode $D_2$, qui joue donc le rôle de drain, est reliée à un étage suiveur de tension à grande impédance d'entrée, qui peut être constitué comme sur les fig. 1 et 2 par deux TMOS $T_2$ et $T_3$ en série. Cet étage fournit la tension de sortie du dispositif $V_S$.

La diode $D_1$ est suivie d'une grille d'isolement $G_3$, de faible longueur par rapport à celle de la grille d'isolement suivante $G_2$ et sensiblement de la même longueur que la grille d'échantillonnage $G_1$. Après la grille $G_3$, on trouve la grille d'échantillonnage $G_1$ portée au potentiel variable V et la grille d'isolement $G_2$. Les grilles $G_2$ et $G_3$ sont protées à un même potentiel constant qui peut être $V_{DD}$.

Les deux grilles d'isolement $G_2$ et $G_3$ sont généralement réalisées par une même métallisation, ce qui permet de rendre la longueur $L_1$ de $G_1$ relativement faible, de l'ordre de 3 um par exemple. La présence de la grille $G_3$ permet de se contenter pour la grille $G_1$ d'une aussi faible longueur. En effet, en l'absence de $G_3$ il faut donner à la grille d'échantillonnage $G_1$ une longueur plus importante afin de compenser une éventuelle pénétration de $D_1$ sous $G_1$.

Les grilles $G_1$, $G_2$ et $G_3$, sont isolées du substrat et isolées entre elles par des couches d'oxyde qui ne sont pas représentées sur la fig. 3a.

Les fig. 3b et 3c représentent des schémas illustrant le fonctionnement du dispositif selon l'invention.

Ces schémas représentent l'évolution du potentiel de surface dans le substrat semi-conducteur, alors que le tension V se trouve au niveau bas, pour la fig. 3b, et alors que la tension V se trouve au niveau haut, pour la fig. 3c. Les zones hachurées indiquent la présence de porteurs minoritaires.

Les tensions $V_{n-1}$ et $V_n$ sont les tensions appliquées à l'entrée du dispositif à deux instants successifs $t_{n-1}$ et $t_n$.

Dans le dispositif selon l'invention, la capacité C se réduit à la connexion entre la diode $D_2$ et l'étage suiveur de tension et peut être considérée comme négligeable.

On a calculé le temps nécessaire à l'équilibrage du potentiel de surface sous la grille d'échantillonnage $G_1$ et la grille d'isolement $G_2$ avec la source du TMOS reliée à $V_e$.

Pour atteindre 90% de $V_e$ en sortie du dispositif, les temps de charge $t_c$ et de décharge $t_d$, c'est-à-dire de croissance et de décroissance du potentiel de surface sous $G_2$ sont les suivants:

$$t_c = 3,3 \cdot (L^2/\mu \cdot V) \tag{3}$$
$$t_d = 2,3 \cdot (L^2/\mu \cdot V) \tag{4}$$

En utilisant les formules (1), (2) et (3), (4), on peut estimer de quelle longueur 1 on peut accroître la longueur $L_2$ de la grille d'isolement $G_2$ tout en conservant le même temps d'acquisition moyen

**0 041 427**

$(t_c + t_d)/2$, que pour les dispositifs des fig. 1 et 2.

Dans les formules (3) et (4), on a $L = L_1 + L_2 + 1$ la grille $G_3$ étant constamment chargée par la diode $D_1$, on n'a pas à prendre en compte son temps de charge.

En posant à priori $1 \gg L_1 + L_2$, on obtient:

$$1 = \sqrt{0{,}82 \cdot \frac{C}{C_{ox}} \cdot \frac{V}{V_0} \cdot \frac{L_1 + L_2}{W}}.$$

Le résultat précédent signifie que si on considère un dispositif selon l'art antérieur tel que celui représenté sur la fig. 2 dont les caractéristiques sont les suivantes:

```
C    =   10 pF
C_ox =   3 · 10⁻⁴ pF/µm²
L₁   =   L₂ = 5 µm
W    =   100 µm
V    =   12 V au niveau haut
V_T  =   2 V
V_e  =   7 V
```

on obtient $1 = 105 \ \mu m$.

Un dispositif selon l'invention dont la longueur de la grille d'isolement $G_2$ égale:

$L_2 + 1 = 5 + 105 = 110 \ \mu m$, possède donc le même temps d'acquisition que le dispositif représenté sur la fig. 2 dont la longueur $L_2$ de la grille d'isolement $G_2$ n'est que de 5 µm.

Dans le dispositif selon l'invention, la longueur de la grille d'isolement $G_2$ est nettement superier à la longueur de la grille d'échantillonnage $G_1$, les largeurs de ces grilles étant les mêmes.

On peut maintenant évaluer quelle est l'amelioration apportée, à temps d'acquisition égal, par le dispositif selon l'invention sur le couplage parasite entre la grille et le drain du TMOS.

Pour le dispositif selon l'art antérieur représenté sur la fig. 2, la tension parasite $V_p$ au point D de $T_1$ qui est due au couplage entre la grille d'échantillonnage et le canal MOS de $T_1$s'écrit:

$$V_p = \frac{Q_c}{C} \cdot \frac{1}{2},$$

où $Q_c$ représente ja quantité de charges prélevée ou restituée par le canal de $T_1$ sous $G_1$ en première approximation pour motié sur le drain et pour moitié sur la source, pour l'établissement de la couche d'invension:

$$V_p = \frac{W \cdot L_1 \cdot C_{ox} \cdot V_0}{C} \cdot \frac{1}{2}. \tag{5}$$

Comme on l'a vu précédemment, une autre cause au couplage parasite entre la grille d'échantillonnage et je drain de $T_1$ est le couplage de la grille d'échantillonnage $G_1$ de $T_1$ avec le drain par l'intermédiaire du substrat.

La fig. 4 représente un schéma électrique illustrant ce couplage.

La capacité $C_G$ regroupe en série la capacité d'oxyde et la capacité de charge d'espaces de la grille d'échantillonnage $G_1$.

La résistance $R_{SUB}$ est la résistance du substrat entre le bord de la zone de charge d'espace et le contact substrat le plus proche qui est généralement réalisé sur la face arrière du dispositif.

Enfin, la résistance $R_1$ est la résistance du substrat entre le bord de la zone de charge d'espace sous la grille d'échantillonnage $G_1$ et sous le drain.

Le parasite dû au couplage par le substrat est d'autant moins important que l'on a:

$$R_{SUB} \ll R_1 \tag{6}$$

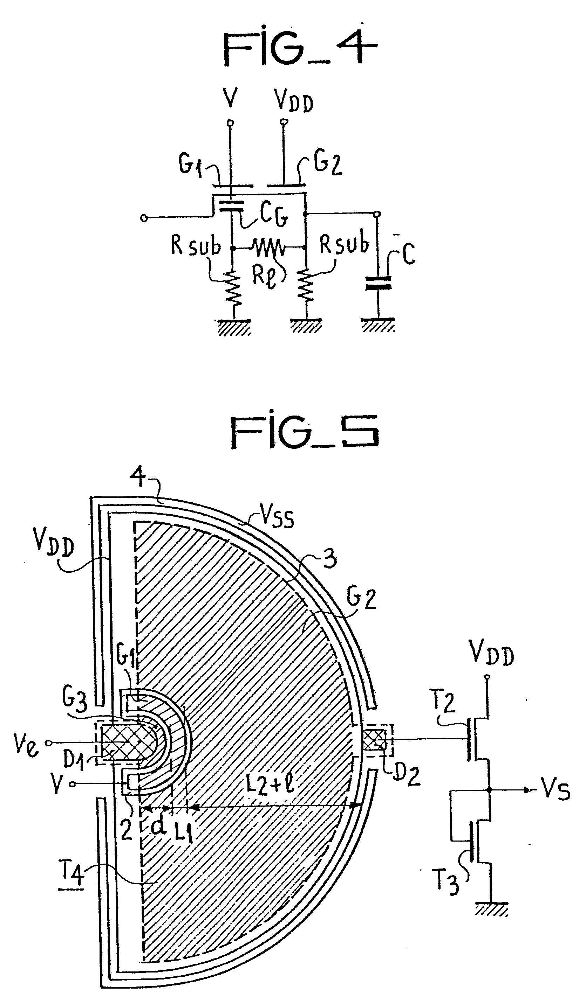

La fig. 5 représente une vue de dessus d'un autre mode de réalisation du dispositif selon l'invention représenté sur la fig. 3a.

Dans ce mode de réalisation, la géométrie de la grille d'isolement $G_2$ est optimale pour que sa capacité soit maximale ce qui permet de diminuer le parasite dû au couplage de la grille d'échantillonnage avec le canal, tout en conservant un temps d'acquisition constant.

Dans ce mode de réalisation, les grilles $G_3$, $G_1$ et $G_2$ de la fig. 3a sont constituées par des secteurs d'anneaux de surface croissante et ayant le même angle au centre. Sur la fig. 5, cet angle au centre $\alpha$ égale 180° et les grilles sont des demi-anneaux, cet angle au centre est tel que: $0 < \alpha \leq 180°$.

Sur la fig. 5, les grilles $G_1$, $G_2$ et $G_3$ ont été hachurées pour plus de clarté.

5

La diode $D_1$ est située au centre des cercles déterminant les anneaux. Son extrêmité qui est enserrée par la grille $G_3$ est également en arc de cercle.

La diode $D_2$ est placée à un endroit quelconque du cercle de plus grand diamètre, c'est-à-dire à la périphérie de la grille $G_2$.

La grille d'échantillonnage $G_1$ est réalisée sur un niveau de métallisation superposé à celui qui porte les grilles $G_2$ et $G_3$; elle est isolée des grilles $G_2$ et $G_3$, par une couche isolante 2.

La grille d'échantillonnage $G_1$ a un rayon interne égal à d et un rayon externe égal à $d + L_1$.

La grille d'isolement $G_2$ à un rayon interne égal à $d + L_1$ et un rayon externe égal à $d + L_1 + L_2 + 1$.

Une diffusion d'isolement 3, en demi-cercle, mis-à-part les décrochements nécessités par les diodes $D_1$ et $D_2$, détermine la zone utile du substrat. La diffusion d'isolement 3 est représentée symboliquement en traits discontinus sur la figure.

Dans cette configuration, les charges issues de la diode $D_1$ ont toutes à parcourir la même distance pour parvenir à la périphérie de $G_2$, dont le potentiel de surface est lu par la diode $D_2$. Le temps d'acquisition est donc constant.

On peut noter que le parasite d'échantillonnage lui-même est affecté pour parvenir jusqu'à la diode $D_2$ du même temps d'acquisition que le signal. Il se trouve ainsi filtré par le canal sous les grilles du TMOS $T_2$ dont le schéma équivalent s'apparente à un réseau de résistances en série chargées par des capacités.

La quantité de charges $Q_c$ prélevé ou restituée par le canal de $T_2$ sous $G_1$ pour l'établissement de la couche d'inversion s'écrit:

$$Q_c = \text{surface de } G_1 \cdot C_{ox} \cdot V_0 = \frac{\alpha}{2} L_1 \cdot (2d + L_1) \cdot C_{ox} \cdot V_0.$$

Il est connu que l'expression du potentiel de surface $\Phi_S$ en fonction de la densité de charge d'inversion $Q$ est:

$$\frac{\Delta \Phi_S}{\Delta Q} = \frac{\gamma}{C_{ox}},$$

où $\gamma$ est un coefficient compris entre 0,7 et 1 qui dépend du dopage du substrat et de l'épaisseur d'oxyde.

D'où la tension parasite $V_P$ introduite au niveau de $D_2$ et qui est due au couplage par le canal:

$$V_p^* = \frac{\gamma}{C_{ox}} \cdot \frac{1}{\text{surface de } G_2} \cdot \frac{Q_c}{2}$$

$$V_p^* = \gamma \cdot \frac{\text{surface de } G_1}{\text{surface de } G_2} \cdot \frac{V_0}{2} = \gamma \cdot \frac{L_1 \cdot (2d + L_1)}{(l + L_2) \cdot (2d + 2L_1 + L_2 + l)} \cdot \frac{V_0}{2}. \tag{7}$$

On constate donc que dans le dispositif selon l'invention, l'importance du parasite par couplage avec le canal est proportionnelle au rapport des surfaces de grilles $G_1$ et $G_2$.

La configuration adoptée sur la fig. 5 correspond à un plus petit rapport que les configurations où $G_1$ et $G_2$ sont rectangulaires, pour une surface de semi-conducteur donnée.

On constate de plus que le rapport des surfaces ne dépend pas de l'angle au centre $\alpha$. On limite l'angle $\alpha$ à 180° car au-delà il est nécessaire de modifier la diode $D_1$ et on augmente la surface de silicium nécessaire.

Pour évaluer l'amélioration apportée, à temps d'acquisition égal, par le dispositif selon l'invention en ce qui concerne le couplage parasite par le canal, on peut écrire le rapport:

$$\frac{V_p^*}{V_p} = \frac{(5)}{(7)} = \frac{C_{ox} \cdot W \cdot L_2}{\gamma \cdot C} \cdot \frac{(l + L_2) \cdot (2d + 2L_1 + L_2 + l)}{(2d + L_1)}.$$

En reprenant les valeurs obtenues précédemment: $L_1 = 5\,\mu m$ et $L_2 + y = 110\,\mu m$ et en prenant: $\gamma = 0,85$ et $d = 5\,\mu m$, on obtient:

$$\frac{V_p^*}{V_p} = 3,4.$$

On obtient donc une réduction par trois environ du parasite par couplage avec le canal.

En ce qui concerne le parasite dû au couplage par le substrat, l'éloignement de la grille d'échantillonnage $G_1$ de la diode $D_2$, favorise l'augmentation de $R_1$ (voir relation (6)).

D'autre part, on réalise un contact avec le substrat 4 qui est porté au potentiel de référence $V_{SS}$, par la face avant du dispositif. Sur la fig. 5, ce contact est en demi-cercle, mis-à-part les interruptions nécessitées par les diodes $D_1$ et $D_2$. Ainsi les contacts avec le substrat peuvent être approchés jusqu'à

0 041 427

10 $\mu$m de $G_1$ et $G_2$. La résistance $R_{SUB}$ est donc minimale.

Le dispositif selon l'invention permet d'obtenir une réduction par 10 environ du parasite par couplage avec le substrat.

Enfin, un dernier avantage du dispositif selon l'invention réside dans le gain de place par rapport à l'art antérieur.

La capacité de stockage du dispositif selon l'invention est constituée par la capacité MOS ayant pour armature la grille d'isolement $G_2$.

Dans le cas de l'exemple numérique choisi, cette capacité vaut:

$$C_o \cdot \frac{\pi}{2} (2d + 2L_1 + L_2 + I) \cdot (L_2 + I) = 6,7 \text{ pF}.$$

La capacité de maintien C d'un dispositif selon l'art antérieur est de 10 pF, ce qui entraîne un gain en surface de l'ordre de 1,5 si la capacité de maintien C est réalisée avec un oxyde de même épaisseur que la grille $G_2$.

## Revendications

1. Dispositif d'échantillonnage et maintien, constitué par un transistor MOS du type tétrode, qui fonctionne en régime triode et qui comprend:

— une première diode ($D_1$) connectée à la tension d'entrée ($V_e$) du dispositif;
— une grille d'échantillonnage ($G_1$) reliée à un potentiel variable (V) et une grille d'isolement ($G_2$) reliée à un potentiel constant ($V_{DD}$), qui suivent la première diode;
— enfin, une deuxième diode ($D_2$) qui suit la grille d'isolement, et qui est connectée à un étage suiveur de tension à grande impédance d'entrée qui fournit la tension de sortie ($V_S$) du dispositif, dispositif caractérisé en ce que le stockage des charges correspondant à chaque échantillon de la tension d'entrée est réalisé sur une capacité MOS ayant pour armature la grille d'isolement ($G_2$) et en ce que la longueur ($L_2 + I$) de la grille d'isolement ($G_2$) est nettement supérieure à la longueur ($L_1$) de la grille d'échantillonnage ($G_1$).

2. Dispositif selon la revendication 1, caractérisé en ce que le rapport des longueurs ($L_2 + I/L_1$) de la grille d'isolement ($G_2$) et de la grille d'échantillonnage ($G_1$) est supérieur à 20.

3. Dispositif selon l'une des revendications 1 ou 2, caractérisé en ce que la grille d'isolement ($G_2$) est reliée à une autre grille d'isolement ($G_3$) qui est située entre la première diode ($D_1$) et la grille d'échantillonnage ($G_1$), cette autre grille d'isolement ($G_3$) ayant une faible longueur par rapport à celle ($L_2 + I$) de la grille d'isolement ($G_2$).

4. Dispositif selon l'une des revendications 1 à 3, caractérisé en ce que la grille d'isolement de faible longueur ($G_3$), la grille d'échantillonnage ($G_1$) et l'autre grille d'isolement ($G_2$) sont des secteurs d'anneau de surface croissante et ayant le même angle au centre ($\alpha$), la première diode ($D_1$) étant située au centre des cercles déterminant les anneaux et la deuxième diode ($D_2$) étant placée à un endroit quelconque à la périphérie de l'autre grille d'isolement ($G_2$).

5. Dispositif selon la revendication 4, caractérisé en ce que l'angle au centre ($\alpha$) des secteurs d'anneau ne dépasse pas 180°.

6. Dispositif selon l'une des revendications 1 à 5, caractérisé en ce qu'un contact (4) avec le substrat est réalisé par la face avant du dispositif et entoure sensiblement tout le dispositif.

## Patentansprüche

1. Tast- und Halteschaltung, bestehend aus einem MOS-Transistor vom Tetrodentyp, der als Triode betrieben wird und enthält:

— eine erste mit der Eingangsspannung ($V_e$) der Schaltung verbundene Diode ($D_1$),
— ein mit einem veränderlichen Potential (V) verbundenes Tastgitter ($G_1$) und ein mit einem konstanten Potential ($V_{DD}$) verbundenes Isolationsgitter ($G_2$), wobei diese Gitter auf die erste Diode folgen;
— schließlich eine zweite Diode ($D_2$), die auf das Isolationsgitter folgt und die an eine Spannungsfolgerstufe großer Eingangsimpedanz angeschlossen ist, welche die Ausgangsspannung ($V_S$) der Schaltung liefert,

dadurch gekennzeichnet, daß die Ladungsspeicherung, die jeder Tastprobe der Eingangsspannung entspricht, in einem MOS-Kondensator erfolgt, der das Isolationsgitter als Armatur enthält, und daß die Länge ($L_2 - I$) des Isolationsgitters ($G_2$) deutlich größer als die Länge ($L_1$) des Tastgitters ($G_1$)

7

**0 041 427**

gewählt ist.

2. Schaltung nach Anspruch 1, dadurch gekennzeichnet, daß das Verhältnis der Längen ($L_2 + I/L_1$) des Isolationsgitters ($G_2$) und des Tastgitters ($G_1$) größer als 20 ist.

3. Schaltung nach einem der Ansprüche 1 oder 2, dadurch gekennzeichnet, daß das Isolationsgitter ($G_2$) mit einem weiteren Isolationsgitter ($G_3$) verbunden ist, das zwischen der ersten Diode ($D_1$) und dem Tastgitter ($G_1$) liegt und eine geringe Länge im Verhältnis zur Länge ($L_2 + I$) des Isolationsgitters ($G_2$) besitzt.

4. Schaltung nach einem der Ansprüche 1 bis 3, dadurch gekennzeichnet, daß das Isolationsgitter geringer Länge ($G_3$), das Tastgitter ($G_1$) und das andere Isolationsgitter ($G_2$) Ringsektoren zunehmender Oberfläche sind und gleichen Zentralwinkel ($\alpha$) besitzen, wobei die erste Diode ($D_1$) im Zentrum der Kreise liegt, die die Ringe bestimmen, während die zweite Diode ($D_2$) an einer beliebigen Stelle am Außenrand des anderen Isolationsgitters ($G_2$) liegt.

5. Schaltung nach Anspruch 4, dadurch gekennzeichnet, daß der Zentrumswinkel ($\alpha$) der Ringsektoren den Wert 180° nicht übersteigt.

6. Schaltung nach einem der Ansprüche 1 bis 5, dadurch gekennzeichnet, daß ein Kontakt (4) mit dem Substrat an der Vorderseite der Schaltung erfolgt und im wesentlichen die ganze Schaltung umgibt.

## Claims

1. A sample and hold device constituted by a MOS transistor of the tetrode type operating under triode conditions and comprising:

— a first diode ($D_1$) connected to the input voltage ($V_e$) of the device,
— a sampling grid ($G_1$) connected to a variable potential (V) and an insulating grid ($G_2$) connected to a constant potential ($V_{DD}$), these grids following the first diode,
— finally, a second diode ($D_2$) following the insulating grid and connected to a voltage follower stage of high input impedance which delivers the output voltage ($V_S$) of the device, characterized in that the storage of the charges corresponding to each sample of the input voltage is realized in a MOS condensor, an armature of which is constituted by the insulating grid ($G_2$) and that the length ($L_2 + I$) of the insulating grid ($G_2$) is substantially greater than the length ($L_1$) of the sampling grid ($G_1$).

2. A device according to claim 1, characterized in that the ratio ($L_2 + I/L_1$) of the lengths of the insulating grid ($G_2$) and of the sampling grid ($G_1$) exceeds 20.

3. A device according to one of the claims 1 or 2, characterized in that the insulating grid ($G_2$) is connected to a second insulating grid ($G_3$) located between the first diode ($D_1$) and the sampling grid ($G_1$), said second insulating grid ($G_3$) being short with respect to the length ($L_2 + I$) of the insulating grid ($G_2$).

4. A device according to one of the claims 1 to 3, characterized in that the insulating grid of short length ($G_3$), the sampling grid ($G_1$) and the other insulating grid ($G_2$) are ring sectors of increasing surface area and with the same center angle ($\alpha$), the first diode ($D_1$) being positioned at the center of the circles defining the rings, whereas the second diode ($D_2$) is located at a random point on the periphery of the other insulating grid ($G_2$).

5. A device according to claim 4, characterized in that the center angle ($\alpha$) of the ring sectors does not exceed 180°.

6. A device according to one of claims 1 to 5, characterized in that a contact (4) with the substrate is provided by the front face of the device and substantially surrounds the complete device.

8

0 041 427

FIG_1

FIG_2

FIG_3-a

FIG_3-b

FIG_3-c

9

# FIG_4

# FIG_5